# EUROPEAN PATENT APPLICATION

(11) **EP 4 215 923 A1**
(43) Date of publication of application: **26.07.2023**
(21) Application number: 22305062.6
(22) Date of filing: 20.01.2022
(51) Int. Cl.: G01Q 60/58

(54) **DEVICE FOR NANOSCALE THERMAL MEASUREMENTS AND ASSOCIATED METHOD FOR MANUFACTURING SAID DEVICE**

(71) Applicant: Centre national de la recherche scientifique, 75016 Paris (FR)
(72) Inventor: BOURGEOIS, Olivier, 38380 SAINT LAURENT DU PONT (FR); SWAMI, Rahul, 38000 GRENOBLE (FR); JULIE, Gwénaelle, 38500 VOIRON (FR); MOTTE, Jean-François, 38500 COUBLEVIE (FR)
(74) Representative: IPAZ

(57) **Abstract**

The invention relates to a probe device for nanoscale thermal measurements comprising an insulating lever, a tip protruding from the insulating lever, a microstructured layer of Niobium Nitride (NbN) extending over only a part of the tip and covering an apex of the tip and/or covering at least one area adjoining the apex of the tip and/or covering, only partly, the insulating lever and at least two conductive leads extending from the insulating lever to the microstructured NbN layer.

## Description

### Field of the invention

The present invention relates to the field of local temperature measurements. The present invention falls under Scanning Thermal Microscopy (SThM) domain.

The present invention concerns a device for measuring temperature, thermal conductivity and/or specific heat at nanometer scale.

The present invention has applications on an industrial scale for quality control as an example. The device according to the invention may be used for hotspots detection, for instance in microcircuits. In particular, the present invention also aims application on nanometer defects detection, optimization of circuits designs and on numerical models.

### Background to the invention

It is known in the art the Lock-In Thermography (LIT) based on irradiating a surface of a sample with a wave and analyzing the reflected wave. The best size resolution of this technique is the tens of microns. LIT is the only technique used at industrial level so far.

It is also known in the art the SThM technique which is a type of scanning probe microscopy. To date, SThM is not used at industrial level due to its lack of temperature resolution.

One of the drawbacks of the LIT of state of the art is the lack of spatial resolution which is at best around tens of microns.

Another common drawback of the devices of state of the art is the lack of sensitivity which is at best around 1.10⁻³ K⁻¹.

### Summary of the invention

An object of the invention is:
- to overcome the drawbacks of the devices of the state of the art, and/or
- to provide a thermal sensor capable of nanometer and/or tens of nanometers scale measurements, and/or
- to provide a thermal sensor which is a consumable intended to be replaced, and/or
- to provide a thermal sensor for measuring temperature, thermal conductivity and/or specific heat of samples surfaces.

To this end, according to the invention, there is provided a Probe device, preferably for thermal measurements, more preferably for nanoscale thermal measurements, comprising:
- an insulating lever, preferably a microlever,
- a tip protruding from the insulating lever,
- a microstructured layer of Niobium Nitride (NbN) extending over, preferably only a part, of the tip and covering an apex of the tip and/or covering at least one area adjoining the apex of the tip and/or covering, only partly, the insulating lever,
- at least two conductive leads extending from the insulating lever to the microstructured NbN layer.

Preferably, the size of the insulating lever is less than 500 µm.

Preferably, the size of the tip is less than 10 µm.

Preferably, the microstructured NbN layer exdents, only partly, over the tip.

Preferably, the microstructured NbN layer covers or coats, only partly, the tip.

Preferably, the microstructured NbN layer extends over or covers or coats an external surface of the tip.

Preferably, the microstructured NbN layer is, partly, in contact, preferably in direct contact, with the external surface of the tip.

Preferably, the at least two conductive leads extend over or covers or coats the external surface of the insulating lever.

Preferably, the at least two conductive leads extend, partly, under the microstructured NbN layer.

Preferably, the at least two conductive leads are, partly, in contact, preferably in direct contact, with the microstructured NbN layer. More preferably, the at least two conductive leads extending partly under the microstructured NbN layer are in contact, preferably in direct contact, with the microstructured NbN layer.

Preferably, the at least two conductive leads are, partly, in contact, preferably in direct contact, with the insulating lever.

Preferably, each of the at least two conductive leads form a layer. Preferably, each layer of conductive leads is, partly, comprised between the insulating lever and the microstructured NbN layer. Preferably, each of the at least two conductive leads comprises a first side or face or surface which is, partly, in contact, preferably in direct contact, with the insulating lever. Preferably, each of the at least two conductive leads comprises a second side or face or surface, which is preferably opposite to the first side or face or surface, which is, partly, in contact, preferably in direct contact, with the microstructured NbN layer.

Preferably, the insulating lever and/or the tip exhibits a low thermal conductivity, namely a thermal conductivity lower than 3 W.m⁻¹.K⁻¹.

Preferably, the probe device according to the invention is a resistive thermometer.

Preferably, the probe device comprises a support from which the insulating lever is extending. Preferably, said support having a size superior to 500 µm.

Preferably, the probe device comprises at least two electrical contact pads provided on the support. Preferably, each of the at least two conductive leads extends from a different electrical contact pads among the at least two electrical contact pads.

Preferably, the contact pads extend over or covers or coats an external surface of the support.

Preferably, the at least conductive leads extend along the insulating lever to the microstructured NbN layer.

Preferably, the microstructured NbN layer forms a strip.

Preferably, the strip extends from a base of the tip towards the apex of tip and/or towards at least one area adjoining the apex of the tip.

More preferably, the strip extends from the base of the tip through the apex of tip and/or through at least one area adjoining the apex of the tip towards the base of the tip.

Preferably, only a part of the microstructured NbN layer covers, only partly, each of the at least two conductive leads.

Preferably, the at least two conductive leads do not cover the apex of the tip and/or do not cover any area adjoining the apex of the tip.

Preferably, the at least two conductive leads do not cover any part of the tip.

At least two conductive leads, among the at least two conductive leads, may be made of a titanium / gold superposed bi-layer.

Preferably, each of the at least two conductive leads are made of a titanium / gold superposed bi-layer.

According to the invention, there is also provided a method for manufacturing a probe device for nanoscale thermal measurements, said method comprising the steps consisting in:
- coating, at least partly, preferably completely or entirely, an insulating lever, intended to be an insulating lever of the probe device, of the probe device and/or, at least partly, preferably completely or entirely, a tip protruding from the insulating lever with a layer of a conductive material, then
- lithograph the layer of conductive material to form at least two leads of conductive material, then
- coating, at least partly, preferably completely or entirely, the tip and/or, at least partly, preferably completely or entirely, an apex of the tip and/or, at least partly, preferably completely or entirely, the at least two leads of conductive material with a layer of Niobium Nitride (NbN), then
- lithograph the NbN layer:
   - to form a microstructured layer of Niobium Nitride (NbN) extending over, preferably only a part of, the tip and covering an apex of the tip and/or covering at least one area adjoining the apex of the tip, and
   - so that the at least two leads of conductive material extend from the insulating lever to the microstructured NbN layer.

Preferably, the step of lithograph the conductive material comprises the steps consisting in:
- subsequently to the step of coating the insulating lever, coating the layer of conductive material with a layer of a first resist, then
- lithograph and develop the first resist, then
- etching the conductive material to form at least two leads of conductive material.

Preferably, the step of lithograph the NbN layer comprises the steps consisting in:
- subsequently to the step of coating the NbN layer, coating the NbN layer with a layer of a second resist, then
- lithograph and develop the second resist, then
- etching the NbN layer to form the microstructured NbN layer.

Preferably, the first and the second resist are the same resist.

Preferably, the first and/or the second resist is a negative resist.

Preferably, the first and/or the second resist is an e-beam resist.

Preferably, the first and/or the second resist is a sterol based molecular resist.

Preferably, a resist developer for developing the first and/or the second resist is:
- a resist developer comprising, in weight, between 0 and 40 % of di-propylene glycol monomethyl ether and between 60 and 100 % of propanediol, or
- a resist developer comprising, preferably consisting in, methyl ethyl ketone.

Preferably, the first and/or the second resist layer is coated by evaporation.

Preferably, the method according to the invention is suitable for manufacturing the probe device according to the invention. More preferably, the method according to the invention is specifically adapted for manufacturing the probe device according to the invention.

Preferably, the probe device is manufactured by the method according to the invention.

### Brief description of the drawings

Further objects, features and advantages will appear from the following detailed description of several embodiments of the invention with references to the drawings, in which:
- FIGURES 1 to 4 are a top view pictures by scanning electronic microscopy of the probe device according to the invention,
- FIGURE 5 is a schematic representation of the manufacturing method of a probe device according to the invention,
- FIGURE 6a) illustrates AFM measurements of the thickness according to the lateral profile of lithograph QSR-5 e resist strips lithograph on gold and SiN layers and developed with QSR-5D2 and MEK, FIGURES 6b) and 6c) are graphs illustrating the normalized thickness, according to the EBL exposure dose, of the edges of the QSR-5 e-resist strips lithograph on gold and SiN layers and developed with QSR-5D2 and MEK according to figure 6a).

### Detail description of embodiments of the invention

The embodiments hereinafter described are not restrictive, other embodiments comprising a selection of features described hereinafter may be considered. A selection may comprise features isolated from a set of features (even if this selection is isolated among a sentence comprising other features thereof), if the selection is sufficient to confer a technical advantage or to distinguish the invention form the state of the art. This selection comprises at least a feature, preferably described by its technical function without structural features, or with a part of structural details if this part is sufficient to confer a technical advantage or to distinguish the invention form the state of the art on its own.

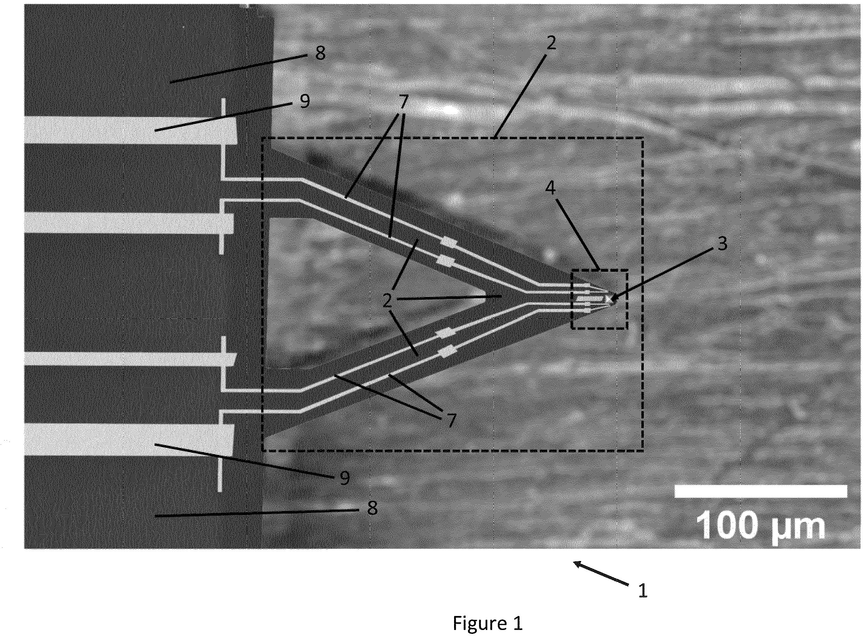

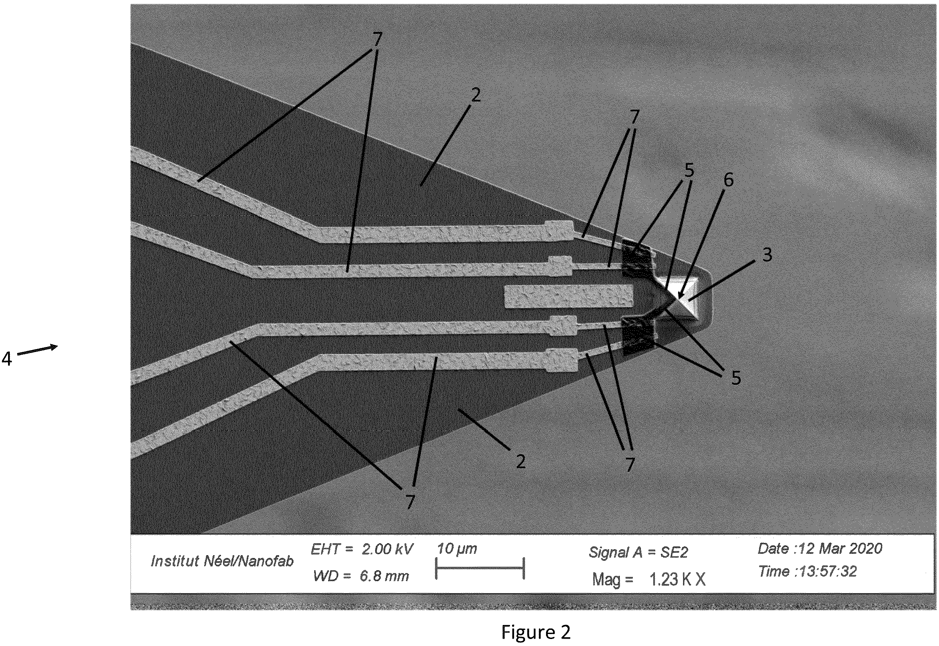

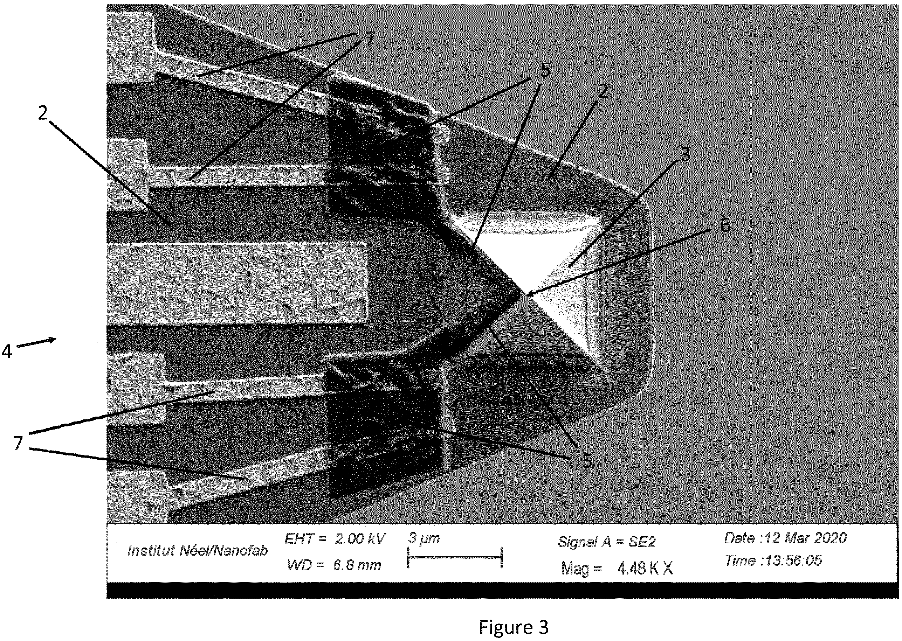

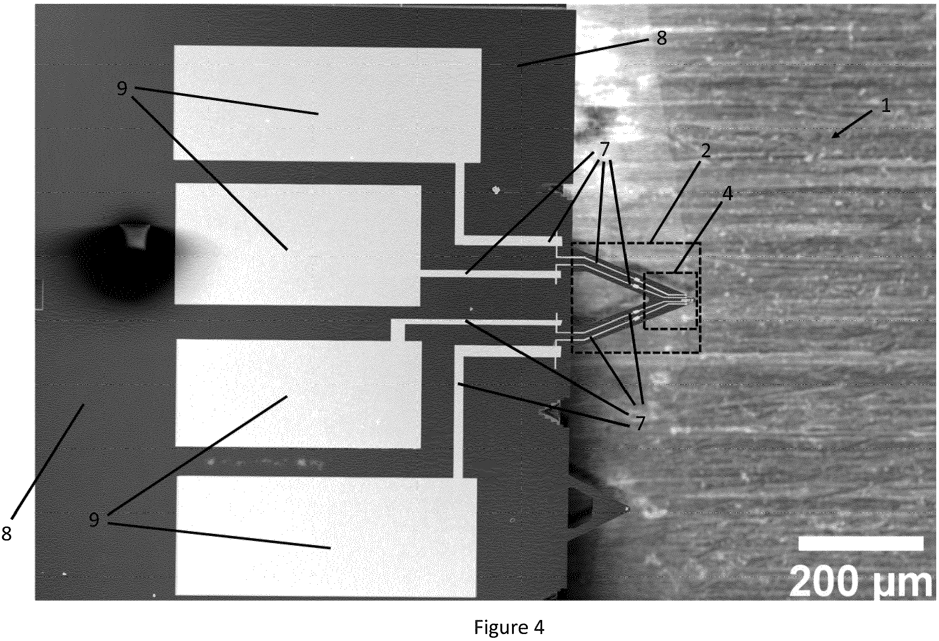

FIGURES 1 to 4 show an embodiment of thermal probe device 1 for nanoscale thermal measurements. The probe device 1 comprises an insulating microlever 2. The probe device 1 further comprises a tip 3 protruding from the insulating microlever 2. The tip 3 is located at the end 4 of the insulating microlever 2. The probe device 1 further comprises a microstructured layer of Niobium Nitride (NbN) 5 forms a strip extending over only a part of the tip 3. Moreover, the NbN microstructured layer strip 5 covers one area adjoining the apex 6 and covers only a part of the insulating microlever 2.

The probe device 1 further comprises at least two conductive leads 7, four conductive leads 7 according to the embodiment, extending from the insulating microlever 2 to the microstructured NbN layer 5.

Only a part of the microstructured NbN layer 5 covers only a part of each of the conductive leads 7. This feature ensures low electrical contact resistance between the leads 7 and the microstructured NbN layer 5.

The thermal probe device 1 according to the invention operates as a resistive thermometer. In particular, the probe device 1 is intended to be used as a near field microscopy device for nanoscale thermal measurements. To that end, the thermal probe 1, in particular the tip 3 of the probe device 1, is intended to be used to scan the surface of a sample to measure its temperature, thermal conductivity and/or specific heat at nanometer scale. The operating mode of the probe device 1 as near field microscopy device according to the embodiment comprises putting the tip 3 of the probe device 1 in contact with the surface of a sample to be analyzed/measured. When in contact with the surface of the sample either a part of the NbN layer 5 covering the apex 6 of the tip 3 which is in contact with the sample and/or a part of NbN layer 5 covering the area adjoining the apex 6 of the tip 3 which in close vicinity with the sample will thermalize with the sample. This thermalisation allows the measurement of a temperature change by measuring a change of the resistance of the NbN layer 5. The measurement of the resistance variation of the NbN layer 5 allows the measurements of the temperature, thermal conductivity and/or the specific heat, at nanometer scale, of the sample.

The NbN thin layer 5 of the probe device 1 constitutes the active component of the thermometer. The NbN exhibits a metal to insulator transition which involves a modification of the resistivity of the material when temperature varies. An increase of the temperature generates a decrease of the resistivity of the NbN and conversely. Moreover, the NbN exhibits a low thermal conductivity and a high temperature coefficient of resistance that can be up to 1.10⁻² K⁻¹ at room temperature and up to 1 K⁻¹ at cryogenic temperatures, typically lower than 120 K. This allows operation of the device with a very high sensitivity in temperature and/or thermal conductivity over a broad temperature range (from 0.05 K to 400 K).

Hence, temperature, thermal conductivity and/or specific heat of surface sample may be measured at nanometer scale by the probe device 1 according to the invention. Furthermore, the nitrogen content of the NbN layer can be tuned to set the optimal working temperature range.

Preferably, the microstructured NbN layer 5 strip has an area as low as possible to limit the electrical impedance of the thermometer and, hence, to improve the sensitivity of the probe device 1.

Preferably, microstructured NbN layer 5 has at least a part extending as close as possible of the apex 6 of the tip 3 to increase the sensitivity of the thermal probe 1. It is an advantage that at least a part of the microstructured NbN layer 5 is as close as possible to the sample to be analyzed to increase the sensitivity of the measurements. To that end, it is also possible that the microstructured NbN layer strip 5 covers the apex 6 of the tip 3.

It is preferable that the conductive leads 7 do not cover the apex 6 of the tip 3 and do not cover any area adjoining the apex of the tip 3. This feature allows to maximize the temperature change inside the NbN layer 5.

The probe device 1 comprises a support 8 from which the insulating microlever 2 is extending.

According to the embodiment, the length of the insulating from the support 8 to the tip is 200 µm. The size of the base of tip is 4 µm per 4 µm. The apex 6 of the tip 3 protrudes from the insulating microlever 2 of 3 µm. The tip 3 may protrude from the insulating microlever 2 of 5, 10 or 15 µm. The size of the support 8 is 1 mm by 3 mm.

The probe device 1 comprises at least two electrical contact pads 9, four contact pads 9 according to the embodiments, provided on the support 8. Each of the conductive leads 7 extends from a different electrical contact pads 8.

The conductive leads 7 are made of a titanium/gold superposed bi-layer.

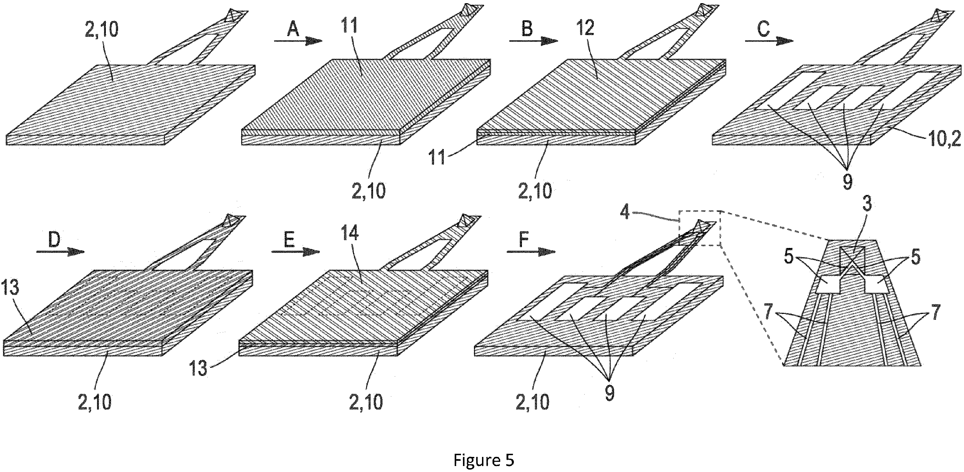

In reference to figure 5, it is also described a method for manufacturing a probe device 1 for nanoscale thermal measurements. Preferably, as illustrated figure 5a, the method is implemented on an Atomic Force Microscopy (AFM) probe 10, for instance a commercial AFM probe 10. The insulating lever 2, the tip and the support, on which the manufacturing method according to the invention is implement, are parts of the AFM probe 10. Although the embodiment has been implement on an AFM probe 10, every component or device comprising an insulating microlever 2 and a tip is suitable for the method according to the invention to be implemented on such component or device.

It is preferable that the microlever 2, the tip and the support of the component or device, the AFM probe 10 according to the embodiment, on which the method is implemented exhibits low thermal conductivity and electrically properties, preferably insulating properties. To that end, the AFM probe 10 according to the invention is made of Silicon nitride (SiN). The tip has a radius of curvature about 15 nm.

As illustrated figure 5, the method comprises the step, step A of figure 5, consisting in coating the insulating microlever 2 and the tip 3 of the AFM probe 10 with a layer of a conductive material 11. The conductive material is a bilayer 11 of Ti/Au. The thickness of the Ti/Au layer 11 is preferably comprised between 1 and 15 nm for the titanium layer, 5 nm according to the embodiment, and between 20 and 150 nm for the gold layer, 50 nm according to the embodiment. The Ti/Au layer 11 was deposited by e-gun evaporation at a base pressure lower than 10⁻⁶ Torr. The Ti/Au layer 11 is chosen because it exhibits a good corrosion resistance and high electrical conductivity. The titanium film acts as an adhesion layer for the gold layer. The NbN layer 5 is deposited above the Ti/Au layer 11 to ensure a very good electrical contact between the NbN layer 5 and the Ti/au layer 11 and hence minimize, during the measurement, the electrical noise originating from the Au/NbN contact.

The method further comprises the step, that corresponds to steps A, B and C of figure 5, consisting in lithograph the layer of conductive material to form the four leads 7 of conductive material. The step of lithograph the layer of conductive material 11 comprises the step, step B of figure 5, consisting in, subsequently to the step of coating the insulating microlever 2, coating the layer of conductive material 11 with a layer 12 of QSR-5 negative e-resist of a thickness comprises between 100 and 300 nm, a thickness of 170 nm according to the embodiment. The QSR-5 negative resist is deposited by thermal evaporation based on Joule effect in a chamber under a pressure of 2.10⁻⁷ mbar. The QSR5 negative resist is a sterol based molecular resist provided by the "Institut Interdisciplinaire d'Innovation Technologique" of Sherbrooke University. During the deposition, the temperature of the molybdenum crucible containing the QSR-5 powder is increased gradually up to 130°C until the desired evaporation rate of around 1.Å.s⁻¹ is reached. Preferably, after the deposition of the the QSR-5 resist layer 12, the AFM probe 10 coated with the QSR-5 resist is kept for 24 hours and protected against light to ensure good adhesion. To promote a high quality resist film 12, it is preferable to deposit the QSR-5 resist at low base pressure (typically a pressure less than 5×10⁻⁷ Torr). To promote a high quality resist film 12, it is also preferable to deposit the QSR-5 resist at low evaporation rate (around 0.1 nm per second).

The step of lithograph the Ti/Au layer further comprises the steps, which are comprised in step C of figure 5, of lithograph and develop the QSR5 negative resist. The step of lithograph the QSR-5 resist layer 12 is carried out by electron beam lithography (EBL) with an accelerating voltage of 5 keV and an optimal dose of 400 µC.cm⁻². The development of the QSR-5 resist is performed in QSR-5D2 developer at 30°C between 1 and 20 minutes, 12 minutes according to the embodiment. The QSR-5D2 developer is made of di-propylene glycol monomethyl ether, at a weight percentage of 0-40 %, and of propanediol, at a weight percentage of 60-100% weight.

The step of lithograph the Ti/Au layer further comprises the step, which is comprised in step C of figure 5, of etching the QSR-5 resist layer 12 together with the layer of conductive material 11 to form the leads 7 and contact pads 9 of conductive material. Then, the obtained patterns of QSR-5 resist are used as a hard mask for dry etching. To obtain the electrical leads 7 and contact pads 9, ion beam etching (IBE) is carried out to remove Ti/Au layers from the unexposed area during the EBL. The IBE is carried out at a power of 400 W in Ar atmosphere with a pressure of 0.1 mTorr. Then, a treatment for removing the resist residues and cleaning the AFM probe may be carried out through, for instance, an oxygen plasma for 2 minutes.

The method further comprises the step, step D of figure 5, consisting in coating the AFM probe 10 and the leads 7 of conductive material with a NbN layer 13. The deposition of the NbN layer 13 thin is carried out by DC-pulsed magnetron sputtering from a high purity (99.95%) Nb target in the presence of Ar/N2 gas. The thickness of NbN layer 13 is comprised between 40 nm and 150 nm, 70 nm according to the invention.

Then, the method for manufacturing comprises the step, corresponding to steps E and F of figure 5, consisting in lithograph the NbN layer 13 to form the microstructured layer of NbN 5 that extends over a part of the tip 3 and covers at least one area adjoining the apex 6 of the tip 3. In that way, the leads 7 of conductive material extend from the insulating micolever 2 to the microstructured NbN layer 5.

The step of lithograph the NbN layer 5 comprises the step, corresponding to step E of figure 5, consisting of, subsequently to the step of coating the NbN layer 13, said step D, with a layer 14 of a QSR-5 negative e-resist of a thickness comprises between 100 and 300 nm, a thickness of 170 nm according to the embodiment. Then, the step of lithograph the NbN layer 13 further comprises the step, comprises in step F of figure 5, consisting of lithograph and develop the QSR-5 negative e-resist layer 14. The step of lithograph the QSR-5 resist layer 14 together with the NbN layer 13 is carried out by electron beam lithography (EBL) with an accelerating voltage of 5 keV and an optimal dose of 400µC.cm⁻². The development of the QSR-5 resist is performed in methyl ethyl Ketone, said MEK, developer at 30°C between 1 and 20 minutes, one and half minutes according to the embodiment. Then, the step of lithograph the NbN layer 13 further comprises the step, comprises in step F of figure 5, consisting in etching the NbN layer 13 to form the microstructured NbN layer 5. The step of lithograph the NbN layer 13, comprises in step F of figure 5, consists in a SF₆ plasma etching for achieving the precise and well-defined patterns of the microstructured NbN layer 5.

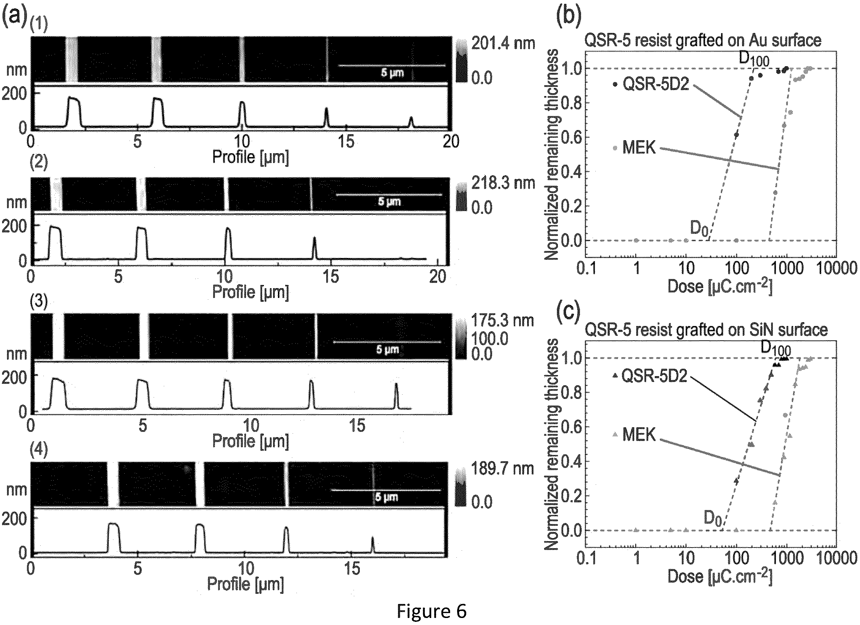

According to figure 6, it is compared the contrast curves of 170 nm thick QSR-5 e-resist layer coated onto a gold and SiN layers and developed either with QSR-5D2 or MEK for rectangles of length-width: 20 µm × 500 nm. Figures 6-a)1) et 6-a)2) illustrates the thickness, according to the lateral profile measured by AFM, of lithograph QSR-5 e resist strips of 50, 100, 200, 400 and 500 nm widths on a gold layer developed with QSR-5D2 under 500 µC.cm⁻² of EBL exposure dose for figure 6-a)1) and with MEK under 1500 µC.cm⁻² of EBL exposure dose for figure 6-a)2). Figures 6-a)3) et 6-a)4) illustrates the evolution the thickness, according to the lateral profile measured by AFM, of lithograph QSR-5 e resist strips of 50, 100, 200, 400, and 500 nm widths on a SiN layer developed with QSR-5D2 under 500 µC.cm⁻² of EBL exposure dose for figure 6-a)3) and the thickness, according to the lateral profile measured by AFM, of lithograph QSR-5 e resist strips of 100, 200, 400 and 500 nm widths on a SiN layer developed with MEK under 1500 µC.cm⁻² of EBL exposure dose for figure 6-a)4). Figure 6-b) illustrates the normalized thickness according to the EBL exposure dose of the edges of QSR-5 e-resist strips illustrate on figures 6-a)1) and 6-a)2). Figure 6-c) illustrates the normalized thickness according to the EBL exposure dose of the edges of QSR-5 e-resist strips illustrate on figures 6-a)3) and 6-a)4).

Contrast curves describe the sharpness of the resist profile as a function of exposure dose of 500 µ, which is written as [log(D₁₀₀/D₀)]⁻¹, where D₀ is the maximum electron dose at which the resist does not exposed and D₁₀₀ is the minimum dose to fully exposed the resist. The term D₁₀₀ is also refers to the sensitivity of the resist. The contrast, D₁₀₀ and D₀ for the QSR-5 resist grafted on Au surface and developed in QSR-5D2 and MEK are 0.7, 230 µC.cm⁻² and 27 µC.cm⁻² and, respectively, 2.86, 1340 µC.cm⁻² and 600 µC.cm⁻². In the case of resist grafted on SiN surface, the contrast D₁₀₀ and D₀ is 0.96, 600 µC.cm⁻² and 55 µC.cm⁻² for QSR-5D2 and 1.69, 1970 µC.cm⁻² and µC.cm⁻² for MEK developer. It is interesting to note that the contrast of the resist depends on the coated surfaces. In addition, the contrast tends to be higher in MEK developer because of the short development time, while the sensitivity of the resist is better in QSR-5D2 developer. Furthermore, the sensitivity obtained for QSR-5 is relativity higher compared to most of the other e-resist that are used for nanofabrication.

The invention is not restricted to embodiments described above and numerous adjustments may be achieved within the scope of the invention.

Thus, in combinable alternatives of previous embodiments:
- the microstructured layer of Niobium Nitride (NbN) 5 covers and/or exten ds over the apex 6 of the tip 3, and/or
- the support has a size superior to 500 µm.

Moreover, features, alternatives and embodiments of the invention may be associated if they are not mutually exclusive of each other.

## Claims

1. Probe device (1) for nanoscale thermal measurements comprising:
- an insulating lever (2),
- a tip (3) protruding from the insulating lever,
- a microstructured layer of Niobium Nitride (NbN) (5) extending over only a part of the tip and covering an apex (6) of the tip and/or covering at least one area adjoining the apex of the tip and/or covering, only partly, the insulating lever,
- at least two conductive leads (7) extending from the insulating lever to the microstructured NbN layer.

2. Probe (1) according to claim 1, comprising a support (8) from which the insulating lever (2) is extending, said support having a size superior to 500 µm.

3. Probe (1) according to claim 2, comprising at least two electrical contact pads (9) provided on the support (8), each of the at least two conductive leads (7) extends from a different electrical contact pads among the at least two electrical contact pads.

4. Probe (1) according to any of the preceding claims, wherein the microstructured NbN layer (5) forms a strip.

5. Probe (1) according to any of the preceding claims, wherein only a part of the microstructured NbN layer (5) covers, only partly, each of the at least two conductive leads (7).

6. Probe (1) according to any of the preceding claims, wherein the at least two conductive leads (7) do not cover the apex (6) of the tip (3) and/or do not cover any area adjoining the apex of the tip.

7. Probe (1) according to any of the preceding claims, wherein at least two conductive leads (7) are made of a titanium / gold superposed bi-layer.

8. Method for manufacturing a probe device for nanoscale thermal measurements, said method comprising the steps consisting of:
- coating, at least partly, an insulating lever and/or, at least partly, a tip protruding from the insulating lever with a layer of a conductive material, then
- lithograph the layer of conductive material to form at least two leads (7) of conductive material, then
- coating, at least partly, the tip and/or, at least partly, an apex of the tip and/or, at least partly, the at least two leads of conductive material with a layer of Niobium Nitride (NbN) (13), then
- lithograph the NbN layer:
• to form a microstructured layer of Niobium Nitride (NbN) (5) extending over only a part of the tip and covering an apex of the tip and/or covering at least one area adjoining the apex of the tip, and
• so that the at least two leads of conductive material extend from the insulating lever to the microstructured NbN layer.

9. Method according to the previous claim, wherein the step of lithograph the conductive material comprises the steps consisting of:
- subsequently to the step of coating the insulating lever, coating the layer of conductive material with a layer of a first resist (12), then
- lithograph and develop the first resist, then
- etching the conductive material to form at least two leads (7) of conductive material.

10. Method according to claim 8 or 9, wherein the step of lithograph the NbN layer (13) comprises the steps consisting of:
- subsequently to the step of coating the NbN layer, coating the NbN layer with a layer of a second resist (14), then
- lithograph and develop the second resist, then
- etching the NbN layer to form the microstructured NbN layer (5).

11. Method according to claim 9 or 10, wherein the first and/or the second resist is a negative resist.

12. Method according to any of claim 9 or 11, wherein the first and/or the second resist is an e-beam resist.

13. Method according to any of claim 9 or 12, wherein the first and/or the second resist is a sterol based molecular resist.

14. Method according to any of claim 9 or 13, wherein a resist developer for developing the first and/or the second resist is:
- a resist developer comprising, in weight, between 0 and 40 % of di-propylene glycol monomethyl ether and between 60 and 100 % of propanediol, or
- a resist developer comprising methyl ethyl ketone.

15. Method according to any of claim 9 or 14, wherein the first and/or the second resist layer is coated by evaporation.
